# EUROPÄISCHE PATENTANMELDUNG

(11) **EP 3 490 011 A1**
(43) Veröffentlichungstag der Anmeldung: **29.05.2019**
(21) Anmeldenummer: 17203251.8
(22) Anmeldetag: 23.11.2017
(51) Int. Cl.: H01L 31/18, H01L 31/0216, H01L 21/268, B23K 26/073

(54) **VERFAHREN ZUR LASERABLATION BEI DER HERSTELLUNG VON SOLARZELLEN**

(71) Anmelder: International Solar Energy Research Center Konstanz E.V., 78467 Konstanz (DE)
(72) Erfinder: THEOBALD, Jens, 79102 Freiburg (DE); HENDEL, Richard, 82362 Weilheim (DE); MAYERHOFER, Roland, 91342 Röttenbach (DE)
(74) Vertreter: Westphal, Mussgnug & Partner Patentanwälte mbB

(57) **Zusammenfassung**

Bereitgestellt wird ein Verfahren zur Laserablation bei der Herstellung von Solarzellen, bei dem auf mindestens 15% der vorderseitigen Oberfläche einer Solarzelle oder einer Solarzellen-Vorläuferstruktur oder auf mindestens 15% der rückseitigen Oberfläche einer Solarzelle oder einer Solarzellen-Vorläuferstruktur eine Materialschicht entfernt wird, indem mit einem Laser ein Energieeintrag in die Materialschicht bewirkt wird, mit einer Schwellfluenz, bei der eine Ablation der Materialschicht erfolgt, bei dem der Laser ein Pulslaser ist, der mit möglichst kurzer Pulsdauer betrieben wird, wobei die Pulsenergie durch möglichst starke Aufweitung des Strahldurchmessers so verteilt wird, dass mit diesem Puls die Schwellfluenz, bei der die Ablation der Materialschicht erfolgt, an jeder beleuchteten Stelle erreicht wird.

## Beschreibung

Strukturierungsprozesse, bei denen gezielt Teile einer Materialschicht von der Vorder- oder Rückseite einer Solarzelle oder einer Solarzellen-Vorläuferstruktur entfernt werden, sind eine für die Herstellung von Solarzellen sehr wichtige Klasse von Prozessen. Mit Solarzellen-Vorläuferstruktur ist dabei ein Zwischenprodukt gemeint, das im Verlauf des Herstellungsprozesses der Solarzelle entsteht.

Ein bekanntes Verfahren, das allgemein zur Durchführung derartiger Strukturierungsprozesse und speziell auch bereits im Zusammenhang mit der Herstellung von Solarzellen verwendet wird, ist die Laserablation. Dabei wird Material, das auf einer Oberfläche vorliegt, durch Beschuss mit dem eine hohe Leistungsdichte aufweisenden Strahl eines gepulsten Lasers abgetragen.

Da der Strahldurchmesser im Fokuspunkt des Laserstrahls typischerweise relativ klein ist, worunter bei der Anwendung im Photovoltaikbereich 20-80pm zu verstehen sind, lassen sich bei exakter Positionierung des Lasers sehr präzise schmale Strukturen erzeugen. Dementsprechend ist die Laserablation derzeit vor allem dann das Verfahren der Wahl, wenn, wie z.B. beim PERC-Solarzellenkonzept, schmale bzw. feine Strukturen geöffnet werden müssen.

Um größere Teilbereiche einer Oberfläche mit einem Laser zu entfernen, sind naturgemäß sehr viele Laserpulse nötig. Um dennoch die Bearbeitungszeit zu minimieren, was für den erwünschten und zur Wettbewerbsfähigkeit auf dem Markt benötigten hohen Durchsatz im Herstellungsprozess notwendig ist, war bisher der Ansatz, einen Pulslaser zu verwenden, der mit einer möglichst hohen Repetitionsrate Pulse mit der zum Erreichen der Schwellfluenz benötigten Energie bereitstellen kann, um auf diese Weise die Fahrgeschwindigkeit, mit der der Laser seine Position relativ zur Oberfläche ändert, maximieren zu können und eine sequentielle, linienweise Abtragung der Oberfläche zu ermöglichen. Dies hat jedoch den Nachteil, dass sehr teure Laser verwendet werden müssen, was eine Erhöhung der Herstellungskosten für die Solarzellen mit sich bringt.

Die Aufgabe der Erfindung besteht somit darin, ein Verfahren zur Laserablation bei der Herstellung von Solarzellen bereitzustellen, das einerseits die Verwendung preisgünstigerer Laserquellen erlaubt und andererseits die Bearbeitungszeit für das Entfernen einer Materialschicht auf großen Oberflächenbereichen zumindest nicht erhöht.

Diese Aufgabe wird gelöst durch ein Verfahren zur Laserablation bei der Herstellung von Solarzellen mit den Merkmalen des Patentanspruchs 1. Vorteilhafte Weiterbildungen der Erfindung sind Gegenstand der abhängigen Ansprüche.

Bei dem erfindungsgemäßen Verfahren zur Laserablation bei der Herstellung von Solarzellen wird auf mindestens 15% der vorderseitigen Oberfläche einer Solarzelle oder einer Solarzellen-Vorläuferstruktur oder auf mindestens 15% der rückseitigen Oberfläche einer Solarzelle oder einer Solarzellen-Vorläuferstruktur eine Materialschicht entfernt. Dies erfolgt, wie bei Laserablationsverfahren üblich, indem mit einem Laser ein Energieeintrag, der größer bzw. gleich der zur Ablation notwendigen Schwellfluenz ist, in die Materialschicht bewirkt wird.

Erfindungswesentlich ist dabei, dass der Laser ein Pulslaser ist, der mit einer möglichst kurzen Pulsdauer betrieben wird, wobei die Pulsenergie durch möglichst starke Aufweitung des Strahldurchmessers im Fokuspunkt so verteilt wird, dass mit diesem Puls die Schwellfluenz, ab der die Ablation der Materialschicht erfolgt, möglichst homogen an jeder beleuchteten Stelle erreicht wird. Unter einer möglichst kurzen Pulsdauer sind dabei insbesondere Pulsdauern von 200ns und darunter zu verstehen.

Der verwendete, insbesondere dioden- oder lampengepumpte (seiten- oder endgepumpt), Pulslaser wird im Gegensatz zu dem bisher für optimal gehaltenen Vorgehen nicht mit einer möglichst hohen Repetitionsrate betrieben, sondern mit einer deutlich niedrigeren Repetitionsrate. Dies erschließt die Verwendung deutlich preisgünstigerer Laserquellen.

Eine sinkende Pulsdauer ergibt sich bei den genannten Lasertypen (dioden- oder lampengepumpt) auf Grund der niedrigeren Repetitionsrate. Bei den höheren Pulsenergien, welche sich aus der niedrigen Repetitionsrate direkt ergeben, werden die hohen Energieniveaus schneller geleert als bei hohen Repetitionsraten, wodurch die Pulsdauer sinkt. Eine Verkürzung der Pulsdauer führt zu einer Effizenzsteigerung des Ablationsprozesses.

Dennoch scheint dies im ersten Zugriff kontraproduktiv zu sein, weil mit der Repetitionsratenreduktion eine Reduktion der Verfahrgeschwindigkeit einhergeht, mit der der Laserstrahl über die Oberfläche gefahren wird, womit die Abtragsrate spürbar reduziert wird, wenn kein weiterer Parameter geändert wird.

Überraschenderweise zeigt sich aber, dass diese Reduktion der Fahrgeschwindigkeit nicht nur kompensiert, sondern sogar überkompensiert werden kann, indem der Strahl im Fokuspunkt aufgeweitet wird, und zwar so weit, dass die Pulsenergie so verteilt wird, dass die Schwellfluenz, ab der die Ablation der Materialschicht erfolgt, an jeder durch den aufgeweiteten Laserstrahl beleuchteten Stelle mit Sicherheit noch erreicht werden kann, wobei die maximale Pulsenergie des Lasers am gewählten Betriebspunkt voll ausgeschöpft wird.

Die Frage, ob die Schwellfluenz an jeder beleuchteten Stelle sicher erreicht wurde, kann für das gegebene System unter den jeweiligen Prozessbedingungen durch Überprüfung des Erfolgs des Ablationsprozesses verifiziert werden, beispielsweise durch schrittweise Vergrößerung des Strahlquerschnitts und Überprüfung, ob die gewünschte Entfernung der Oberflächenschicht noch stattgefunden hat. Erreicht man einen Strahlquerschnitt, bei dem dies nicht mehr der Fall ist, kann man dann entweder direkt zu dem davor verwendeten Strahlquerschnitt zurückgehen oder in kleineren Schritten den Strahlquerschnitt wieder vergrößern, bis die gewünschte Entfernung der Oberflächenschicht wieder sicher stattfindet. Die oben genannte Frage kann aber auch theoretisch durch Berechnung beantwortet werden. Es ist aber zweckmäßig, bei der Berechnung der maximalen Spotfläche eine Toleranz hinsichtlich der verfügbaren Laserleistung mit einzuplanen. Der Rest bis zur Maximalleistung bleibt dann als Toleranz für Prozessschwankungen und Leistungsverlust der Laserdioden erhalten.

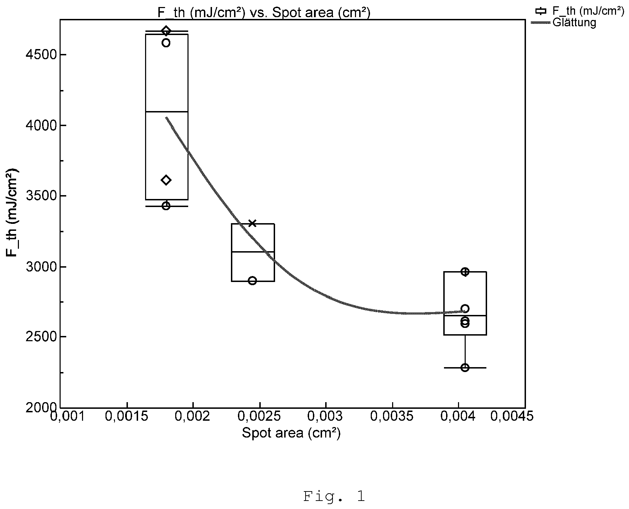

Durch die Aufweitung des Strahlquerschnitts sinkt die Anzahl der Punkte, die zur großflächigen Entfernung einer Materialschicht angefahren werden müssen, signifikant ab, was aber für sich genommen eigentlich nicht ausreicht, um die beobachtete Reduktion der Prozessdauer für das großflächige Entfernen der Oberfläche zu erklären. Vielmehr hat es den Anschein, dass darüber hinaus die Schwellfluenz mit sinkender Pulsdauer des Laserpulses und mit steigender Beleuchtungsfläche erniedrigt wird, wie weiter unten anhand der Figur 1 veranschaulicht wird.

Besonders vorteilhaft lässt sich das erfindungsgemäße Verfahren bei der großflächigen Entfernung von Siliziumnitridschichten anwenden.

Durch das erfindungsgemäße Vorgehen wird erstmals die Möglichkeit erschlossen, die auch mit preisgünstigen Nd:YAG Lasern realisierbare Ablationsfläche pro Zeiteinheit so zu steigern, dass sie als Laser für großflächige Laserablationsprozesse im Produktionsprozess auch unter kommerziellen Gesichtspunkten betrachtet einsetzbar werden.

Ein Aspekt, der zumindest mit dafür verantwortlich sein kann, dass das erfindungsgemäße Aufweiten des Strahldurchmessers im Fokuspunkt in Verbindung mit einer Ablation mit Laserpulsen mit möglichst kurzer Pulsdauer überraschend effektiv ist, lässt sich anhand der Figur 1 aufzeigen.

Figur 1 ist eine Darstellung von bei unterschiedlichen Experimenten gewonnenen experimentellen Daten für die Ablation einer Siliziumnitridschicht, die eine von den Erfindern beobachtete Abhängigkeit der auf der Ordinate aufgetragenen Ablations-Schwellfluenz Fₜₕ (in mJ/cm²) von der auf der Abszisse aufgetragenen Spotgröße des Laserspots im Fokuspunkt (in cm²) veranschaulichen. Je größer die Fläche des Laserspots im Fokus ist, desto geringer wird die Ablations-Schwellfluenz. Da die Abbildung Daten aus verschiedenen Experimenten vereint, entsteht aufgrund zusätzlicher Variationen bzw. geänderter Bedingungen eine relativ große Standardabweichung. Der beobachtete, sicher reproduzierbare Effekt, ist (wahrscheinlich) auf die Schädigungswahrscheinlichkeit zurückzuführen, die bei gleicher Fluenz für größere Fläche größer ist und fällt (wahrscheinlich) für unterschiedliche abzutragende Schichten unterschiedlich aus. Dementsprechend wird durch die Aufweitung des Strahldurchmessers im Fokuspunkt eine weitere Effizienzsteigerung im Ablationsprozess bewirkt.

## Patentansprüche

1. Verfahren zur Laserablation bei der Herstellung von Solarzellen, bei dem auf mindestens 15% der vorderseitigen Oberfläche einer Solarzelle oder einer Solarzellen-Vorläuferstruktur oder auf mindestens 15% der rückseitigen Oberfläche einer Solarzelle oder einer Solarzellen-Vorläuferstruktur eine Materialschicht entfernt wird, indem mit einem Laser ein Energieeintrag in die Materialschicht bewirkt wird, mit einer Schwellfluenz, bei der eine Ablation der Materialschicht erfolgt,
**dadurch gekennzeichnet, dass** der Laser ein Pulslaser ist, der mit möglichst kurzer Pulsdauer betrieben wird, wobei die Pulsenergie durch Aufweitung des Strahldurchmessers im Fokuspunkt möglichst weit verteilt wird, das heißt soweit, dass mit dem Puls die Schwellfluenz, bei der die Ablation der Materialschicht erfolgt, noch an jeder beleuchteten Stelle sicher erreicht wird.

2. Verfahren nach Anspruch 1,
**dadurch gekennzeichnet, dass** die Materialschicht eine Siliziumnitridschicht ist.

3. Verfahren nach Anspruch 1 oder 2,
**dadurch gekennzeichnet, dass** der Pulslaser ein Nd:YAG Laser ist.
